# EUROPEAN PATENT SPECIFICATION

(11) **EP 4 411 794 B1**
(45) Date of publication and mention of the grant of the patent: **09.12.2026**
(21) Application number: 22875189.7
(22) Date of filing: 30.09.2022
(51) Int. Cl.: H10P 72/30

(54) **FALLING PREVENTION DEVICE AND AIR TRANSPORT VEHICLE**
FALLVERHINDERUNGSVORRICHTUNG UND LUFTTRANSPORTFAHRZEUG
DISPOSITIF DE PRÉVENTION DE CHUTE ET VÉHICULE DE TRANSPORT D'AIR

(30) Priority: 30.09.2021 CN 202111163791
(43) Date of publication of application: 07.08.2024
(73) Proprietor: Meetfuture Technology (Shanghai) Co., Ltd., Shanghai 200131 (CN)
(72) Inventor: DU, Baobao, Shanghai 200131 (CN); MIAO, Feng, Shanghai 200131 (CN)
(74) Representative: Balder IP Law, S.L.
(86) International application number: PCT/CN2022/123435
(87) International publication number: WO 2023/051809

(56) References cited:
- CN-A- 109 292 447
- CN-A- 111 908 114
- CN-A- 113 808 981
- CN-A- 113 808 981
- CN-U- 207 752 988
- CN-U- 213 293 966
- JP-A- 2010 126 278
- JP-B2- 5 169 065
- KR-A- 20030 044 775
- US-A1- 2008 100 852
- US-A1- 2020 223 455
- US-A1- 2020 223 455
- US-A1- 2020 331 503

## Description

### TECHNICAL FIELD

Embodiments of the present application relate to the technical field of automatic control, more specifically to a semiconductor manufacturing equipment, and in particular to an anti-drop device and an overhead hoist vehicle including the same.

### BACKGROUND

In a semiconductor manufacturing factory, an overhead hoist vehicle (i.e., overhead travelling crane) configured to transport wafer boxes overhead is generally provided, since wafers are fragile and valuable items that need to be transported in the air within the factory, so the overhead hoist vehicle needs an anti-drop device.

In the anti-drop device of the overhead hoist vehicle in the related technologies, a retractable drive structure generally adopts a stepper motor which is generally cooperated with a reducer and a customized cam to perform extending or retracting, resulting in a large volume, complex structure, and bulky structure of the mechanism. Additionally, the cam is a customized part, which is difficult to process and has low consistency, low fault tolerance of the rack, and difficult to install and debug, which is not conducive to the long-term stable operation of the equipment.

Based on this, a technical solution is provided according the present application to solve the above technical problems.

JP5169065B2 discloses a conveyance device provided with a drop preventing means preventing drop of the conveyed object moved to a fixed position for conveyance by extending from the lower side of the object to the downside thereof, and a conveying means conveying the object.

US2020/331503A1 discloses a transport vehicle comprising a pair of swing suppression units, a moving mechanism configured to move at least one of the swing suppression units in the traveling direction and a buffer mechanism configured to allow the swing suppression unit that has been moved to the first position by the drive of the drive unit to move to the traveling direction after stopping the drive of the drive unit.

KR20030044775A provides an overhead traveling carriage provided with a hoist and traveling along a trajectory provided above a floor, comprising: a chuck mechanism provided on a hoist for supporting an upper portion of the article.

US2020/223455A1 provides an overhead transport vehicle comprising: a gripper to grip the container with the lid oriented in a width direction crossing a traveling direction, a pair of frames disposed at front and back in the traveling direction relative to the gripper, and a first lid drop-preventing member pivotable along a horizontal plane about a pivot shaft in a vertical direction.

JP2010126278A provides a moving vehicle includes a gripping part capable of gripping the article in the suspended state, a fall prevention body positionally changeable between the support position and the retreated position, and positional change drive means for drivingly changing the position of the fall prevention body between the support position and the retreated position.

### SUMMARY

The invention is set out in the appended set of claims.

An anti-drop device applied to an overhead hoist vehicle is provided according to the present application, and the anti-drop device includes a mounting plate, an electric motor, a first support seat, a second support seat, a ball screw, a slider connecting seat, two bearing seats, and a quadrilateral linkage mechanism. The quadrilateral linkage mechanism includes a quadrilateral linkage structure including a first connecting arm, a second connecting arm, a third connecting arm, and a fourth connecting arm. The electrical motor, the first support seat, and the second support seat are installed on the mounting plate, the ball screw passes through the slider connecting seat and is supported between the first support seat and the second support seat, the second connecting arm and the fourth connecting arm in the quadrilateral linkage mechanism are installed on the mounting plate by the two bearing seats, respectively. A first end of the slider connecting seat is connected to the first connecting arm, and an output shaft of the electrical motor is connected to an end of the ball screw. The electrical motor is configured to drive the ball screw, to drive the slider connecting seat to move, and the slider connecting seat is configured to drive the first connecting arm to move, to enable the quadrilateral linkage mechanism to extend or retract, so that a target is prevented from dropping in response to the target object being transported by the overhead hoist vehicle.

### BRIEF DESCRIPTION OF THE DRAWINGS

The following will provide a clear and understandable explanation of the preferred embodiments in conjunction with the accompanying drawings, the above features, technical features, advantages, and embodiments are further described.
FIG. 1 is an axonometric view showing a front side of an anti-drop device provided according to the present application;
FIG. 2 is an axonometric view showing a rear side of an anti-drop device provided according to the present application;
FIG. 3 is a top view of an anti-drop device provided according to the present application during retracting;
FIG. 4 is a top view of an anti-drop device provided according to the present application during extending;
FIG. 5 is an axonometric view showing a top view of an anti-drop device provided according to the present application when a clamping block extending;
FIG. 6 is a three-dimensional view of an anti-drop device provided according to the present application when clamping an object; and
FIG. 7 is a front view of an anti-drop device provided according to the present application when clamping an object.

### DETAILED DESCRIPTION

In order to provide a clearer explanation of the embodiments of the present application or the technical solutions in the prior art, the specific implementation methods of the present application will be explained below with reference to the accompanying drawings. Obviously, the accompanying drawings in the following description are only some embodiments of the present application. For those of ordinary skills in the art, other drawings and embodiments may be obtained based on these drawings without any creative labor.

Based on the present application, those skilled in the art should understand that one aspect described herein can be independently implemented with any other aspect, and that two or more of these aspects can be combined in various ways. For example, any number and aspects described herein can be used to implement device and/or practical a method. In addition, other structures and/or functionalities other than those described herein may be used to implement the device and/or practice the method.

It should also be noted that the accompanying drawings provided according to the following embodiments only illustrate the basic concept of the present application in a schematic manner. The figures only display the components related to the present application and are not necessarily drawn based on the actual number, shape, and size of the components during implementation. The type, quantity, and proportion of each component during actual implementation can be arbitrarily changed, and the component layout may also be more complex.

In addition, in the description of the present application, it should be understood that the directional words such as "up", "down", "inside", "outside", and the quantitative words such as "first", "second", "third", etc. described in the example embodiments of the present application are described from the perspective shown in the accompanying drawings and should not be understood as limitation on the embodiments of the present application, and should not be understood as indicating or implying relative importance or implying the quantity of technical features.

Automated transportation in an automated manufacturing plant can be implemented using automated small transportation vehicles, which shuttle between various workstations, timely and effectively transports materials, thereby not only improving transportation efficiency and ensuring timely and punctual processing operations, but also reducing personnel circulation, especially in clean workshops in a semiconductor manufacturing factory. The role of automated small transportation vehicles is particularly important.

In a manufacturing workshop or factory that produce precision components such as wafers, overhead hoist vehicles (i.e., overhead travelling cranes) are generally used to carry wafer boxes. Wafers are fragile and valuable items, and if they drop during high-altitude carrying, significant economic losses happen. Therefore, in order to prevent valuable raw materials or components such as wafers from dropping, an anti-drop device is generally provided on the overhead hoist vehicle.

In the production and operation process, the anti-drop device of the overhead hoist vehicle in the related technologies generally adopts a stepper motor to cooperate with a reducer and a customized cam to perform extending or retracting, resulting in a large volume, complex structure. Moreover, the anti-drop device including the stepper motor and the reducer is installed on the overhead hoist vehicle, which requires a bigger upper space in the factory. Additionally, the cam is a customized part, which is difficult to process and has low consistency, low fault tolerance of the rack, and difficult to install and debug, which is not conducive to the long-term stable operation of the equipment.

A telescopic device in the anti-drop device in the present application can extend or retract with the cooperation of a ball screw and an electrical motor. The anti-drop device including the newly designed telescopic device has a simple structure, smaller volume, and high degree of standardization of components.

The anti-drop device includes a quadrilateral linkage mechanism, where each side is a connecting arm, and adjacent connecting arms are connected in pairs and can rotate relative to each other, so that a distance between the opposite sides can be changed, and the quadrilateral linkage mechanism is able to extend or retract. The anti-drop device further includes an electrical motor and a ball screw, where the ball screw is installed on the support seat of the anti-drop device, and the electrical motor is connected to the ball screw. In response to the electrical motor being started, the ball screw is driven to rotate around its central axis. The anti-drop device further includes a slider connecting seat, a part of which is connected to a connecting arm of the quadrilateral linkage mechanism. The ball screw passes through the slider connecting seat, and in response to the ball screw being driven to rotate by the electrical motor, the slider connecting seat moves along the ball screw, thereby driving the connecting arm of the quadrilateral linkage mechanism to extend or retract for transportation, to prevent the target object from dropping when transported by the overhead hoist vehicle.

The following is a description of the technical solutions provided by each embodiment of the present application, in conjunction with the accompanying drawings.

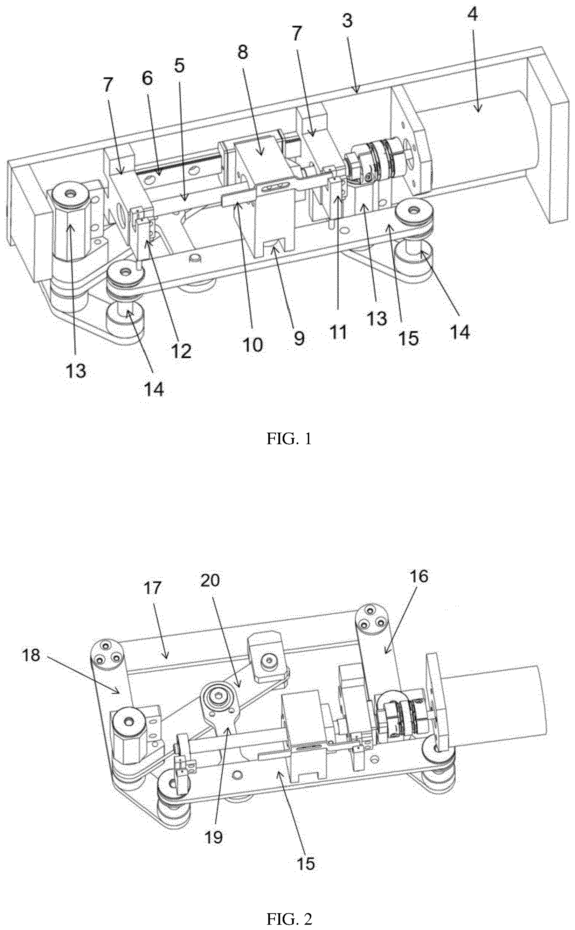

As shown in FIG. 1 to FIG. 5, the anti-drop device includes a mounting plate 3, an electrical motor 4, a ball screw 5, a support seat 7 (e.g., a left support seat defined as a first support seat and a right support seat defined as a second support seat), a slider connecting seat 8, and a quadrilateral linkage mechanism. The quadrilateral linkage mechanism includes a quadrilateral linkage structure including a first connecting arm 15, a second connecting arm 16, a third connecting arm 17, and a fourth connecting arm 18.

The electrical motor 4, the first support seat, and the second support seat are installed on the mounting plate 3. The ball screw 5 passes through the slider connecting seat 8 and is supported between the first support seat and the second support seat. The second connecting arm 16 and the fourth connecting arm 18 arranged opposite to each other in the quadrilateral linkage mechanism, are respectively installed on the mounting plate 3 through two bearing seats 13. The first end of the slider connecting seat 8 (as shown in the bottom surface of the slider connecting seat in FIG. 1) is connected to the first connecting arm 15, and an output shaft of the electrical motor 4 is connected to one end of ball screw 5.

At this point, in response to the electrical motor 4 working, the following mechanical movements are achieved: the electrical motor 4 drives the ball screw 5, the ball screw 5 drives the slider connecting seat 8 to move, the slider connecting seat 8 drives the first connecting arm 15 to move, the first connecting arm 15 drives the second connecting arm 16, the third connecting arm 17, and the fourth connecting arm 18 to move, which causes the quadrilateral linkage mechanism to extend or retract.

It should be noted that the second connecting arm 16 and the fourth connecting arm 18 are arranged opposite to each other in the quadrilateral linkage structure, that is, the second connecting arm 16 and the fourth connecting arm 18 are in opposite positions of the quadrilateral structure, and the first connecting arm 15 and the third connecting arm 17 are also in opposite positions of the quadrilateral structure. Since the second connecting arm 16 and the fourth connecting arm 18 rotate around the two bearing seats 13, respectively. In response to the slider connecting seat 8 driving the first connecting arm 15 to move, the distance between the two opposite sides of the quadrilateral linkage structure will change, which causes the quadrilateral linkage mechanism to extend or retract. In response to the quadrilateral linkage structure retracting, a smaller space is taken, and does not affect the normal grasping and clamping of the target object performed by the overhead hoist vehicle. In response to the quadrilateral linkage structure extending, the quadrilateral linkage structure can extend below the target object to prevent the target object from dropping and avoid production safety from being affected.

It should be noted that by controlling the electrical motor to start or stop, a stroke of the slider connecting seat 8 along the ball screw 5 is controlled, thereby controlling the extension or retraction amplitude of the quadrilateral linkage structure.

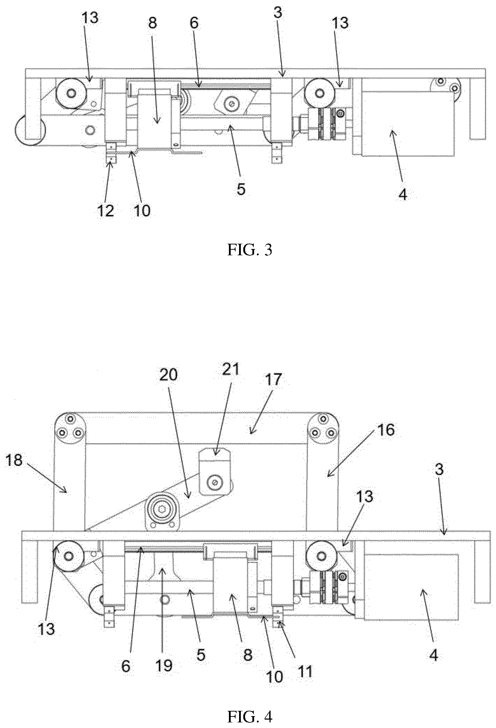

For example, the electrical motor is controlled to start or stop, so that the slider connecting seat 8 stays at the end of the ball screw 5 close to the electrical motor 4, and the quadrilateral linkage structure is extending, as shown in FIG. 2 and FIG. 4.

For example, the electrical motor is controlled to start or stop, so that the slider connecting seat 8 stays at the end of the ball screw 5 away from to the electrical motor 4, and the quadrilateral linkage structure is retracting, as shown in FIG. 1 and FIG. 3.

It should also be noted that the anti-drop device is configured to cooperate with the overhead hoist vehicle. For example, in response to a gripper on the overhead hoist vehicle being not grasping the object, the electrical motor 4 drives the ball screw 5 to retract the quadrilateral linkage structure. In response to the gripper on the overhead hoist vehicle grasping the object, the electrical motor 4 drives the ball screw 5 to enable the quadrilateral linkage structure to extend. The quadrilateral linkage structure extends to form an "anti-drop arm", which supports the object to prevent it from dropping and plays a protective role when it accidentally drops.

It should be noted that a suitable type of motors can be selected based on the reliability and convenience of matching with the ball screw, for example, DC motors can be preferred.

The anti-drop device provided according to the present application can be applied to the overhead hoist vehicle. A single motor is used to drive the quadrilateral linkage mechanism to extend or retract through a ball screw and slider connecting seat. In response to the quadrilateral linkage mechanism being extended, it can play a protective role in the event of accidental dropping of materials carried by the overhead hoist vehicle from high altitude. In response to the quadrilateral linkage mechanism being retracting, the overhead hoist vehicle is provided with space to load (e.g., grasping wafer boxes), to meet the needs of material loading operation. The anti-drop device has a simple structure, and its structural components (e.g., ball screw, connecting arm, slider connecting seat, and bearing seat) are easy to standardize, which makes it convenient for component selection and procurement. The drive structure is simplified, lightweight, and small in size, which is conducive to equipment installation and debugging, thereby improving the error tolerance rate of the rack and the long-term stability of the equipment.

In some embodiments, the anti-drop device further includes a slide rail 6, where the slide rail 6 is installed on the mounting plate 3. The second end of the slide connecting seat 8 (as shown on the rear surface of the slide connecting seat in FIG. 1) is slidably connected to the slide rail 6 to enable the slide connecting seat 8 to move along the slide rail 6.

In some implementations, the second end of the slider connecting seat 8 is fixedly connected to the connecting seat of the slide rail 6.

By providing the second end of the slide rail 6 slidably connected to the slider connecting seat 8, the stability of the slider connecting seat 8 is achieved, which makes the movement process of the slider connecting seat 8 along the ball screw 5 more stable, thereby better driving the extension or retraction of the quadrilateral linkage mechanism, and improving the fault tolerance rate of the rack and the long-term working stability of the equipment.

In some embodiments, a groove is internally defined below the first end of the slider connecting seat 8, and a roller bearing 9 is arranged in the groove. The roller bearing 9 is connected to the first connecting arm 15.

In some embodiments, the roller bearing 9 includes a self-aligning roller bearing, a thrust self-aligning roller bearing, a tapered roller bearing, and a cylindrical roller bearing.

A groove is defined internally below the first end of the slider connecting seat 8, which provides installation space for the roller bearing 9 and facilitating the formation of a compact structure. There are various types and models of roller bearings, and they have the characteristic of high rotation accuracy. By connecting the first connecting arm of the quadrilateral linkage structure through the roller bearing 9, the movement of the quadrilateral linkage structure can be better matched.

In some embodiments, as shown in FIG. 1, the anti-drop device further includes a detection panel 10, a first sensor 11, and a second sensor 12, and the detection panel 10 is installed on the slider connecting seat 8.

The first sensor 11 and the detection panel 10 are configured to cooperate with each other to detect whether the quadrilateral linkage mechanism extends to a first predetermined position or not, the second sensor 12 and the detection panel 10 are configured to cooperate with each other to detect whether the quadrilateral linkage mechanism retracts to a second predetermined position or not.

In some embodiments, the first sensor 11, the second sensor 12, and the detection panel 10 achieve the following cooperative actions: as shown in FIG. 4, in response to the quadrilateral linkage mechanism extends to the first predetermined position (e.g., the predetermined position where the quadrilateral linkage mechanism is fully extended), the first predetermined position includes positions of the four connecting arms of the quadrilateral linkage mechanism in response to a distance between the first connecting arm 15 and the third connecting arm 17 being maximum. The detection panel 10 is located within the sensing range of the first sensor 11, which sends a sensing signal to represent that the quadrilateral linkage mechanism extends to the first predetermined position. As shown in FIG. 3, the quadrilateral linkage mechanism retracts to a second predetermined position (e.g., the predetermined position when the quadrilateral linkage mechanism is fully retracted), the second predetermined position includes positions of the four connecting arms of the quadrilateral linkage mechanism in response to a distance between the first connecting arm 15 and the third connecting arm 17 being smallest. In this case, the detection panel 10 is within the sensing range of the second sensor 12, and the second sensor 12 sends a sensing signal, to represent that the quadrilateral linkage mechanism retracts to the second predetermined position.

In some embodiments, a detection panel 10 is arranged on the first connecting arm 15. Since the first end of the slider connecting seat 8 is connected to the first connecting arm 15, in response to the slider connecting seat 8 moving, the first connecting arm 15 moves with the slider connecting seat 8, that is the slider connecting seat 8 and the first connecting arm 15 move synchronously. Therefore, the detection panel 10 arranged on the first connecting arm 15 can also characterize whether the quadrilateral linkage mechanism has reached the first predetermined position or the second predetermined position.

In some embodiments, the first sensor 11 includes a magnetoelectric sensor, a photoelectric sensor. Of course, the second sensor 12 includes a magnetoelectric sensor, a photoelectric sensor.

In some embodiments, the first sensor 11 is installed on the first support seat, and the second sensor 12 is installed on the second support seat.

In some embodiments, as shown in FIG. 1, the first sensor 11 is installed on a side on the first support seat opposite to the mounting plate 3, and the second sensor 12 is installed on a side on the second support seat opposite to the mounting plate 3.

In some embodiments, the first sensor 11 is installed above the first support seat, and the second sensor 12 is installed above the second support seat.

In some embodiments, as shown in FIG. 1, the first sensor 11 includes a first light emitting component and a first light receiving component, where the first light emitting component and the first light receiving component are arranged opposite to each other to output a sensing signal in response to the first light emitting component and the first light receiving component being blocked by the detection panel 10.

In some embodiments, the second sensor 12 includes a second light emitting component and a second light receiving component, where the second light emitting component and the second light receiving component are arranged opposite to each other to output a sensing signal in response to the second light emitting component and the second light receiving component being blocked by the detection panel 10.

In some embodiments, the detection panel 10 is a long-strip-shaped detection panel. An end of the long-strip-shaped detection panel is arranged between the first light emitting component and the first light receiving component, the first sensor 11 is configured to output a first signal, and the first signal is used to represent that the quadrilateral linkage mechanism extends to the first predetermined position. The other end of the long-strip-shaped detection panel is arranged between the second light emitting component and the second light receiving component, the second sensor 12 is configured to output a second signal, and the second signal is used to represent that the quadrilateral linkage mechanism retracts to the second predetermined position.

In some embodiments, by using the long-strip-shaped detection panel (i.e. the detection panel 10), the first light emitting component and the first light receiving component, as well as the second light emitting component and the second light receiving component, the following cooperative actions can be achieved: as shown in FIG. 3, in response to the quadrilateral linkage mechanism retracting to the second predetermined position, that is, in response to the quadrilateral linkage structure retracting, the right end of the long-strip-shaped detection panel is located between the second light emitting component and the second light receiving component, to trigger the second sensor 12 to send a second signal to represent that the quadrilateral linkage mechanism retracts to a second predetermined position. As shown in FIG. 4, in response to the quadrilateral linkage mechanism extending to the first predetermined position, that is, in response to the quadrilateral linkage structure extending, the left end of the long-strip-shaped detection panel is located between the first light emitting component and the first light receiving component, to trigger the first sensor 11 to send a first signal to represent that the quadrilateral linkage mechanism extends to the first predetermined position.

In some embodiments, as shown in FIG. 1 to FIG. 4, the anti-drop device further includes a fifth connecting arm 19, a sixth connecting arm 20, and a clamping block 21. The first end of the fifth connecting arm 19 is rotatably connected to the first connecting arm 15, the second end of the fifth connecting arm 19 is rotatably connected to the sixth connecting arm 20, the first end of the sixth connecting arm 20 is rotatably connected to the corresponding bearing seat 13, and the clamping block 21 is rotatably connected to the second end of the sixth connecting arm 20. The first connecting arm 15, the fifth connecting arm 19, and the sixth connecting arm 20 form a triangular linkage mechanism to synchronously extend or retract with the quadrilateral linkage mechanism. In response to the triangular linkage mechanism extending, the clamping block 21 is configured to clamp the object, which can reduce the shaking of the clamped object.

The above connecting structure can achieve the following linkage effect: as shown in FIG. 2 and FIG. 4, in response to the first connecting arm 15 driving the quadrilateral linkage mechanism to extend, the first connecting arm 15 drives the fifth connecting arm 19 to move to a side away from the mounting plate 3 (as shown in FIG.4, the fifth connecting arm 19 moves upwards), and the fifth connecting arm 19 drives the sixth connecting arm 20 to also move to a side away from the mounting plate 3. Due to the fact that the first end of the sixth connecting arm 20 is fixed on the bearing seat 13 and rotatably connected to the corresponding bearing seat 13. under the pushing of the fifth connecting arm 19, the clamping block 21 connected to the second end of the sixth connecting arm 20 moves to a side away from the mounting plate 3, which causes the clamping block 21 to approach and compress the clamped object of the overhead hoist vehicle, thereby achieving a clamping effect and preventing the clamped object from shaking.

As shown in FIG. 3, in response to the first connecting arm 15 driving the quadrilateral linkage mechanism to retract, the first connecting arm 15 drives the fifth connecting arm 19 to move towards the same side of the mounting plate 3 (as shown in FIG. 3, the fifth connecting arm 19 moves downwards), and the fifth connecting arm 19 drives the sixth connecting arm 20 to also move towards the same side of the mounting plate 3. Since the first end of the sixth connecting arm 20 is fixed on the bearing seat 13 and rotatably connected to the corresponding bearing seat 13, under the pulling of the fifth connecting arm 19, the second end of the sixth connecting arm 20 and the clamping block 21 retract to the same side of the mounting plate 3, which provides space for the overhead hoist vehicle to grasp the clamped object.

With the fifth connecting arm 19, the sixth connecting arm 20, and the clamping block 21, as well as corresponding connection settings, the anti-drop device can not only prevent the clamped object from accidentally dropping, but also play a role in preventing the clamped object from shaking. Moreover, with a triangular linkage mechanism, the clamping block 21 approaches and clamps the clamped object from a side of the clamped object. The structure of the anti-drop device is simple, and component selection and procurement of the anti-drop device are convenient.

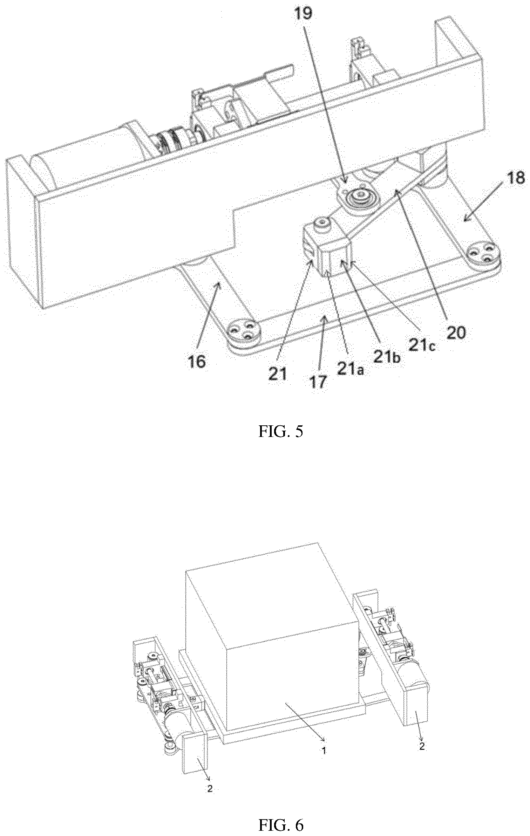

In some embodiments, as shown in FIG. 2, FIG. 4, and FIG. 5, the clamping block 21 includes a first target surface in a predetermined shape, which is an end face in contact with an object when clamping the object, as shown in the middle end face of the clamping block 21 (i.e., the first target surface 21b in FIG. 5).

In some embodiments, the first target surface is in a flat shape such as a rectangle or square to increase the contact area with the clamped object.

It should be noted that the surface of the first target surface can be coated or pasted with patches to adjust the friction force of the first target surface

In some embodiments, as shown in FIG. 5, the clamping block 21 further includes a second target surface 21a and a third target surface 21c. The second target surface 21a and the third target surface 21c are arranged on two sides of the first target surface 21b to enable the second target surface 21a or the third target surface 21c in the triangular linkage mechanism to contact the object before the first target surface 21b during extending.

In some embodiments, in response to the triangular linkage mechanism extending, the second target surface 21a or the third target surface 21c on the clamping block 21 first approaches the clamped object. Since the second target surface 21a and the third target surface 21c are adjacent to the first target surface 21b and form an obtuse angle structure, in response to the triangular linkage mechanism continuing to approach the clamped object, the clamping block 21 is deflected at an obtuse angle under the opposing thrust of the triangular linkage mechanism and the clamped object, resulting in contact between the first target surface 21b and the clamped object, forming a stable clamping contact surface.

Based on the same application concept, an overhead hoist vehicle is further provided according to the embodiments of the present application, the overhead hoist vehicle includes an anti-drop device according to any of the above embodiments. The anti-drop device is arranged inside the overhead hoist vehicle, so that under the drive of the electrical motor 4, the quadrilateral linkage mechanism extends at a lower part of the overhead hoist vehicle or retracts into the overhead hoist vehicle.

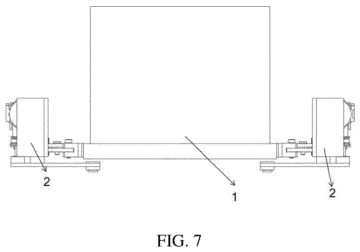

As shown in FIG. 6 to FIG. 7, after the overhead hoist vehicle (not shown in the figure) grabs the object (e.g., a wafer box), the quadrilateral linkage mechanism of the anti-drop device 2 extends below the overhead hoist vehicle, such as below the object 1. In response to the object 1 dropping, the quadrilateral linkage mechanism will stably carry the object 1, thereby effectively prevent the object from dropping.

In some embodiments, the triangular linkage mechanism of the anti-drop device can also provide shaking protection for the clamped object, thereby reducing the amplitude of shaking and improving production safety.

In some embodiments, in response to the overhead hoist vehicle (not shown in the figure) does not grasp the clamped object (e.g., a wafer box), the anti-drop device retracts to the inside of the overhead hoist vehicle (not shown), so that a smaller space is taken, and does not affect the normal grasping and clamping of the target object performed by the overhead hoist vehicle.

It should be noted that the above embodiments can be freely combined as needed. The above are only the preferred embodiments of the present application. It should be pointed out that for those of ordinary skills in the art, several improvements and modifications may be made without departing from the principles of the present application. These improvements and modifications shall fall within the scope of the invention being solely defined by the appended claims.

## Claims

1. An anti-drop device applied to an overhead hoist vehicle, comprising a mounting plate (3), an electric motor (4), a first support seat, a second support seat, a ball screw (5), a slider connecting seat (8), two bearing seats (13), and a quadrilateral linkage mechanism, wherein the quadrilateral linkage mechanism comprises a quadrilateral linkage structure composed of a first connecting arm (15), a second connecting arm (16), a third connecting arm (17), and a fourth connecting arm (18),
wherein the second connecting arm (16) and the fourth connecting arm (18) are arranged opposite to each other and the first connecting arm (15) and the third connecting arm (17) are arranged opposite to each other, wherein adjacent connecting arms are connected in pairs and are configured to rotate relative to each other;
wherein the electrical motor (4), the first support seat, and the second support seat are installed on the mounting plate (3), the ball screw (5) passes through the slider connecting seat (8) and is supported between the first support seat and the second support seat, the second connecting arm (16) and the fourth connecting arm (18) in the quadrilateral linkage mechanism are installed on the mounting plate (3) by the two bearing seats (13), respectively, a first end of the slider connecting seat (8) is connected to the first connecting arm (15), and an output shaft of the electrical motor (4) is connected to an end of the ball screw (5); wherein the second connecting arm (16) is configured to rotate around one bearing seat (13) of the two bearing seats (13) and the fourth connecting arm (18) is configured to rotate around the other bearing seat (13) of the two bearing seats (13);
wherein the electrical motor (4) is configured to drive the ball screw (5), to drive the slider connecting seat (8) to move, and the slider connecting seat (8) is configured to drive the first connecting arm (15) to move, to enable the quadrilateral linkage mechanism to extend or retract, so that a target is prevent from dropping in response to the target object being transported by the overhead hoist vehicle; and
wherein a groove is internally defined below the first end of the slider connecting seat (8), a roller bearing (9) is installed in the groove, and the first end of the slider connecting seat (8) is connected to the first connecting arm (15) by the roller bearing (9).

2. The anti-drop device according to claim 1, further comprising a slide rail (6) installed on the mounting plate (3), wherein a second end of the slider connecting seat (8) is slidably connected to the slide rail (6) to enable the second end of the slider connecting seat (8) to move along the slide rail (6).

3. The anti-drop device according to claim 1 or claim 2, further comprising a first sensor (11), a second sensor (12), and a detection panel (10), wherein the detection panel (10) is installed on the slider connecting seat (8); and
wherein the first sensor (11) and the detection panel (10) are configured to cooperate with each other to detect whether the quadrilateral linkage mechanism extends to a first predetermined position or not, the second sensor (12) and the detection panel (10) are configured to cooperate with each other to detect whether the quadrilateral linkage mechanism retracts to a second predetermined position or not.

4. The anti-drop device according to claim 3, wherein the first sensor (11) is installed on the first support seat, and the second sensor (12) is installed on the second support seat.

5. The anti-drop device according to claim 3 or claim 4, wherein the first sensor (11) comprises a first light emitting component and a first light receiving component arranged opposite to each other;
wherein the second sensor (12) comprises a second light emitting component and a second light receiving component arranged opposite to each other;
wherein the detection panel (10) is a long-strip-shaped detection panel;
wherein in response to an end of the long-strip-shaped detection panel being arranged between the first light emitting component and the first light receiving component, the first sensor (11) is configured to output a first signal, and the first signal is used to represent that the quadrilateral linkage mechanism extends to the first predetermined position; and
wherein in response to the other end of the long-strip-shaped detection panel being arranged between the second light emitting component and the second light receiving component, the second sensor (12) is configured to output a second signal, and the second signal is used to represent that the quadrilateral linkage mechanism retracts to the second predetermined position.

6. The anti-drop device according to any one of claims 1 to 5, further comprising a fifth connecting arm (19), a sixth connecting arm (20), and a clamping block (21);
wherein a first end of the fifth connecting arm (19) is rotatably connected to the first connecting arm (15), a second end of the fifth connecting arm (19) is rotatably connected to the sixth connecting arm (20), a first end of the sixth connecting arm (20) is rotatably connected to the other bearing seat (13) of the two bearing seats (13) corresponding to the fourth connecting arm (18), and a second end of the sixth connecting arm (20) is rotatably connected to the clamping block (21); and
wherein the first connecting arm (15), the fifth connecting arm (19), and the sixth connecting arm (20) form a triangular linkage mechanism to synchronously extend or retract with the quadrilateral linkage mechanism, and the clamping block (21) is configured to clamp an object in response to the triangular linkage mechanism extending.

7. The anti-drop device according to claim 6, wherein the clamping block (21) comprises a first target surface (21b) with a predetermined surface shape, and the first target surface (21b) is an end face in contact with the object during clamping.

8. The anti-drop device according to claim 7, wherein the clamping block (21) further comprises a second target surface (21a) and a third target surface (21c) arranged on two sides of the first target surface (21b), to enable the second target surface (21a) or the third target surface (21c) to be in contact with the object before the first target surface (21b) being in contact with the object in response to the triangular linkage mechanism extending.

9. The anti-drop device according to claim 7, wherein the first target surface (21b) is in a shape of rectangular or square.

10. The anti-drop device according to claim 3, wherein the first sensor (11) comprises a magnetoelectric sensor, or a photoelectric sensor, and the second sensor (12) comprises a magnetoelectric sensor, or a photoelectric sensor.

11. An overhead hoist vehicle, comprising an anti-drop device according any one of claims 1 to 10, wherein the anti-drop device is arranged inside of the overhead hoist vehicle, to enable a quadrilateral linkage mechanism to extend at a lower part of the overhead hoist vehicle or retract to the inside of the overhead hoist vehicle in response to the quadrilateral linkage mechanism being driven by an electrical motor (4).

## Patentansprüche

1. Absturzsicherungsvorrichtung, die an einem Überkopf-Hebefahrzeug angewendet wird, umfassend eine Montageplatte (3), einen Elektromotor (4), einen ersten Stützsitz, einen zweiten Stützsitz, einen Kugelgewindetrieb (5), einen Schieberverbindungssitz (8), zwei Lagersitze (13) und einen viereckigen Gestängemechanismus, wobei der viereckige Gestängemechanismus eine viereckige Gestängestruktur umfasst, die aus einem ersten Verbindungsarm (15), einem zweiten Verbindungsarm (16), einem dritten Verbindungsarm (17) und einem vierten Verbindungsarm (18) besteht,
wobei der zweite Verbindungsarm (16) und der vierte Verbindungsarm (18) einander gegenüberliegend angeordnet sind und der erste Verbindungsarm (15) und der dritte Verbindungsarm (17) einander gegenüberliegend angeordnet sind, wobei benachbarte Verbindungsarme paarweise verbunden sind und dazu konfiguriert sind, sich relativ zueinander zu drehen;
wobei der Elektromotor (4), der erste Stützsitz und der zweite Stützsitz an der Montageplatte (3) installiert sind, der Kugelgewindetrieb (5) durch den Schieberverbindungssitz (8) hindurchgeht und zwischen dem ersten Stützsitz und dem zweiten Stützsitz gestützt ist, der zweite Verbindungsarm (16) und der vierte Verbindungsarm (18) in dem viereckigen Gestängemechanismus jeweils durch die zwei Lagersitze (13) an der Montageplatte (3) installiert sind, ein erstes Ende des Schieberverbindungssitzes (8) mit dem ersten Verbindungsarm (15) verbunden ist und eine Abtriebswelle des Elektromotors (4) mit einem Ende des Kugelgewindetriebs (5) verbunden ist; wobei der zweite Verbindungsarm (16) dazu konfiguriert ist, sich um einen Lagersitz (13) der zwei Lagersitze (13) zu drehen, und der vierte Verbindungsarm (18) dazu konfiguriert ist, sich um den anderen Lagersitz (13) der zwei Lagersitze (13) zu drehen;
wobei der Elektromotor (4) dazu konfiguriert ist, den Kugelgewindetrieb (5) anzutreiben, um den Schieberverbindungssitz (8) zur Bewegung anzutreiben, und der Schieberverbindungssitz (8) dazu konfiguriert ist, den ersten Verbindungsarm (15) zur Bewegung anzutreiben, um es dem viereckigen Gestängemechanismus zu ermöglichen, auszufahren oder einzufahren, sodass ein Ziel als Reaktion darauf, dass das Zielobjekt von dem Überkopf-Hebefahrzeug transportiert wird, am Herunterfallen gehindert wird; und
wobei eine Nut innen unterhalb des ersten Endes des Schieberverbindungssitzes (8) definiert ist, ein Rollenlager (9) in der Nut installiert ist und das erste Ende des Schieberverbindungssitzes (8) durch das Rollenlager (9) mit dem ersten Verbindungsarm (15) verbunden ist.

2. Absturzsicherungsvorrichtung nach Anspruch 1, ferner umfassend eine an der Montageplatte (3) installierte Gleitschiene (6), wobei ein zweites Ende des Schieberverbindungssitzes (8) verschiebbar mit der Gleitschiene (6) verbunden ist, um es dem zweiten Ende des Schieberverbindungssitzes (8) zu ermöglichen, sich entlang der Gleitschiene (6) zu bewegen.

3. Absturzsicherungsvorrichtung nach Anspruch 1 oder Anspruch 2, ferner umfassend einen ersten Sensor (11), einen zweiten Sensor (12) und eine Erfassungsplatte (10), wobei die Erfassungsplatte (10) an dem Schieberverbindungssitz (8) installiert ist; und
wobei der erste Sensor (11) und die Erfassungsplatte (10) dazu konfiguriert sind, miteinander zusammenzuwirken, um zu erfassen, ob der viereckige Gestängemechanismus bis zu einer ersten vorbestimmten Position ausfährt oder nicht, der zweite Sensor (12) und die Erfassungsplatte (10) dazu konfiguriert sind, miteinander zusammenzuwirken, um zu erfassen, ob der viereckige Gestängemechanismus bis zu einer zweiten vorbestimmten Position einfährt oder nicht.

4. Absturzsicherungsvorrichtung nach Anspruch 3, wobei der erste Sensor (11) an dem ersten Stützsitz installiert ist und der zweite Sensor (12) an dem zweiten Stützsitz installiert ist.

5. Absturzsicherungsvorrichtung nach Anspruch 3 oder Anspruch 4, wobei der erste Sensor (11) eine erste lichtemittierende Komponente und eine erste lichtempfangende Komponente umfasst, die einander gegenüberliegend angeordnet sind;
wobei der zweite Sensor (12) eine zweite lichtemittierende Komponente und eine zweite lichtempfangende Komponente umfasst, die einander gegenüberliegend angeordnet sind;
wobei die Erfassungsplatte (10) eine langstreifenförmige Erfassungsplatte ist;
wobei als Reaktion darauf, dass ein Ende der langstreifenförmigen Erfassungsplatte zwischen der ersten lichtemittierenden Komponente und der ersten lichtempfangenden Komponente angeordnet ist, der erste Sensor (11) dazu konfiguriert ist, ein erstes Signal auszugeben, und das erste Signal verwendet wird, um darzustellen, dass der viereckige Gestängemechanismus bis zu der ersten vorbestimmten Position ausfährt; und
wobei als Reaktion darauf, dass das andere Ende der langstreifenförmigen Erfassungsplatte zwischen der zweiten lichtemittierenden Komponente und der zweiten lichtempfangenden Komponente angeordnet ist, der zweite Sensor (12) dazu konfiguriert ist, ein zweites Signal auszugeben, und das zweite Signal verwendet wird, um darzustellen, dass der viereckige Gestängemechanismus bis zu der zweiten vorbestimmten Position einfährt.

6. Absturzsicherungsvorrichtung nach einem der Ansprüche 1 bis 5, ferner umfassend einen fünften Verbindungsarm (19), einen sechsten Verbindungsarm (20) und einen Klemmblock (21);
wobei ein erstes Ende des fünften Verbindungsarms (19) drehbar mit dem ersten Verbindungsarm (15) verbunden ist, ein zweites Ende des fünften Verbindungsarms (19) drehbar mit dem sechsten Verbindungsarm (20) verbunden ist, ein erstes Ende des sechsten Verbindungsarms (20) drehbar mit dem anderen Lagersitz (13) der zwei Lagersitze (13), der dem vierten Verbindungsarm (18) entspricht, verbunden ist, und ein zweites Ende des sechsten Verbindungsarms (20) drehbar mit dem Klemmblock (21) verbunden ist; und
wobei der erste Verbindungsarm (15), der fünfte Verbindungsarm (19) und der sechste Verbindungsarm (20) einen dreieckigen Gestängemechanismus bilden, um synchron mit dem viereckigen Gestängemechanismus auszufahren oder einzufahren, und der Klemmblock (21) dazu konfiguriert ist, ein Objekt als Reaktion auf das Ausfahren des dreieckigen Gestängemechanismus zu klemmen.

7. Absturzsicherungsvorrichtung nach Anspruch 6, wobei der Klemmblock (21) eine erste Zielfläche (21b) mit einer vorbestimmten Flächenform umfasst und die erste Zielfläche (21b) eine Stirnfläche ist, die während des Klemmens mit dem Objekt in Kontakt ist.

8. Absturzsicherungsvorrichtung nach Anspruch 7, wobei der Klemmblock (21) ferner eine zweite Zielfläche (21a) und eine dritte Zielfläche (21c) umfasst, die auf zwei Seiten der ersten Zielfläche (21b) angeordnet sind, um es der zweiten Zielfläche (21a) oder der dritten Zielfläche (21c) zu ermöglichen, als Reaktion auf das Ausfahren des dreieckigen Gestängemechanismus mit dem Objekt in Kontakt zu sein, bevor die erste Zielfläche (21b) mit dem Objekt in Kontakt ist.

9. Absturzsicherungsvorrichtung nach Anspruch 7, wobei die erste Zielfläche (21b) eine rechteckige oder quadratische Form aufweist.

10. Absturzsicherungsvorrichtung nach Anspruch 3, wobei der erste Sensor (11) einen magnetoelektrischen Sensor oder einen photoelektrischen Sensor umfasst und der zweite Sensor (12) einen magnetoelektrischen Sensor oder einen photoelektrischen Sensor umfasst.

11. Überkopf-Hebefahrzeug, umfassend eine Absturzsicherungsvorrichtung nach einem der Ansprüche 1 bis 10, wobei die Absturzsicherungsvorrichtung innerhalb des Überkopf-Hebefahrzeugs angeordnet ist, um es einem viereckigen Gestängemechanismus zu ermöglichen, als Reaktion darauf, dass der viereckige Gestängemechanismus von einem Elektromotor (4) angetrieben wird, an einem unteren Teil des Überkopf-Hebefahrzeugs auszufahren oder in das Innere des Überkopf-Hebefahrzeugs einzufahren.

## Revendications

1. Dispositif anti-chute appliqué à un véhicule de levage suspendu, comprenant une plaque de montage (3), un moteur électrique (4), un premier siège de support, un second siège de support, une vis à billes (5), un siège de liaison de coulisseau (8), deux sièges de palier (13) et un mécanisme de tringlerie quadrilatère, dans lequel le mécanisme de tringlerie quadrilatère comprend une structure de tringlerie quadrilatère composée d'un premier bras de liaison (15), d'un deuxième bras de liaison (16), d'un troisième bras de liaison (17) et d'un quatrième bras de liaison (18),
dans lequel le deuxième bras de liaison (16) et le quatrième bras de liaison (18) sont agencés à l'opposé l'un de l'autre et le premier bras de liaison (15) et le troisième bras de liaison (17) sont agencés à l'opposé l'un de l'autre, dans lequel des bras de liaison adjacents sont reliés par paires et sont configurés pour tourner l'un par rapport à l'autre ;
dans lequel le moteur électrique (4), le premier siège de support et le second siège de support sont installés sur la plaque de montage (3), la vis à billes (5) traverse le siège de liaison de coulisseau (8) et est supportée entre le premier siège de support et le second siège de support, le deuxième bras de liaison (16) et le quatrième bras de liaison (18) dans le mécanisme de tringlerie quadrilatère sont installés sur la plaque de montage (3) par les deux sièges de palier (13), respectivement, une première extrémité du siège de liaison de coulisseau (8) est reliée au premier bras de liaison (15), et un arbre de sortie du moteur électrique (4) est relié à une extrémité de la vis à billes (5) ; dans lequel le deuxième bras de liaison (16) est configuré pour tourner autour d'un siège de palier (13) des deux sièges de palier (13) et le quatrième bras de liaison (18) est configuré pour tourner autour de l'autre siège de palier (13) des deux sièges de palier (13) ;
dans lequel le moteur électrique (4) est configuré pour entraîner la vis à billes (5), pour entraîner le siège de liaison de coulisseau (8) en mouvement, et le siège de liaison de coulisseau (8) est configuré pour entraîner le premier bras de liaison (15) en mouvement, pour permettre au mécanisme de tringlerie quadrilatère de se déployer ou de se rétracter, de sorte qu'une cible est empêchée de chuter en réponse au transport de l'objet cible par le véhicule de levage suspendu ; et
dans lequel une rainure est définie intérieurement sous la première extrémité du siège de liaison de coulisseau (8), un roulement à rouleaux (9) est installé dans la rainure, et la première extrémité du siège de liaison de coulisseau (8) est reliée au premier bras de liaison (15) par le roulement à rouleaux (9).

2. Dispositif anti-chute selon la revendication 1, comprenant en outre un rail de glissement (6) installé sur la plaque de montage (3), dans lequel une seconde extrémité du siège de liaison de coulisseau (8) est reliée de manière coulissante au rail de glissement (6) pour permettre à la seconde extrémité du siège de liaison de coulisseau (8) de se déplacer le long du rail de glissement (6).

3. Dispositif anti-chute selon la revendication 1 ou la revendication 2, comprenant en outre un premier capteur (11), un second capteur (12) et un panneau de détection (10), dans lequel le panneau de détection (10) est installé sur le siège de liaison de coulisseau (8) ; et
dans lequel le premier capteur (11) et le panneau de détection (10) sont configurés pour coopérer l'un avec l'autre pour détecter si le mécanisme de tringlerie quadrilatère se déploie ou non jusqu'à une première position prédéterminée, le second capteur (12) et le panneau de détection (10) sont configurés pour coopérer l'un avec l'autre pour détecter si le mécanisme de tringlerie quadrilatère se rétracte ou non jusqu'à une seconde position prédéterminée.

4. Dispositif anti-chute selon la revendication 3, dans lequel le premier capteur (11) est installé sur le premier siège de support, et le second capteur (12) est installé sur le second siège de support.

5. Dispositif anti-chute selon la revendication 3 ou la revendication 4, dans lequel le premier capteur (11) comprend un premier composant émetteur de lumière et un premier composant récepteur de lumière agencés à l'opposé l'un de l'autre ;
dans lequel le second capteur (12) comprend un second composant émetteur de lumière et un second composant récepteur de lumière agencés à l'opposé l'un de l'autre ;
dans lequel le panneau de détection (10) est un panneau de détection en forme de longue bande ;
dans lequel, en réponse au fait qu'une extrémité du panneau de détection en forme de longue bande est agencée entre le premier composant émetteur de lumière et le premier composant récepteur de lumière, le premier capteur (11) est configuré pour délivrer un premier signal, et le premier signal est utilisé pour représenter que le mécanisme de tringlerie quadrilatère se déploie jusqu'à la première position prédéterminée ; et
dans lequel, en réponse au fait que l'autre extrémité du panneau de détection en forme de longue bande est agencée entre le second composant émetteur de lumière et le second composant récepteur de lumière, le second capteur (12) est configuré pour délivrer un second signal, et le second signal est utilisé pour représenter que le mécanisme de tringlerie quadrilatère se rétracte jusqu'à la seconde position prédéterminée.

6. Dispositif anti-chute selon l'une quelconque des revendications 1 à 5, comprenant en outre un cinquième bras de liaison (19), un sixième bras de liaison (20) et un bloc de serrage (21) ;
dans lequel une première extrémité du cinquième bras de liaison (19) est reliée de manière rotative au premier bras de liaison (15), une seconde extrémité du cinquième bras de liaison (19) est reliée de manière rotative au sixième bras de liaison (20), une première extrémité du sixième bras de liaison (20) est reliée de manière rotative à l'autre siège de palier (13) des deux sièges de palier (13) correspondant au quatrième bras de liaison (18), et une seconde extrémité du sixième bras de liaison (20) est reliée de manière rotative au bloc de serrage (21) ; et
dans lequel le premier bras de liaison (15), le cinquième bras de liaison (19) et le sixième bras de liaison (20) forment un mécanisme de tringlerie triangulaire pour se déployer ou se rétracter de manière synchrone avec le mécanisme de tringlerie quadrilatère, et le bloc de serrage (21) est configuré pour serrer un objet en réponse au déploiement du mécanisme de tringlerie triangulaire.

7. Dispositif anti-chute selon la revendication 6, dans lequel le bloc de serrage (21) comprend une première surface cible (21b) ayant une forme de surface prédéterminée, et la première surface cible (21b) est une face d'extrémité en contact avec l'objet pendant le serrage.

8. Dispositif anti-chute selon la revendication 7, dans lequel le bloc de serrage (21) comprend en outre une deuxième surface cible (21a) et une troisième surface cible (21c) agencées sur deux côtés de la première surface cible (21b), pour permettre à la deuxième surface cible (21a) ou à la troisième surface cible (21c) d'être en contact avec l'objet avant que la première surface cible (21b) soit en contact avec l'objet en réponse au déploiement du mécanisme de tringlerie triangulaire.

9. Dispositif anti-chute selon la revendication 7, dans lequel la première surface cible (21b) est de forme rectangulaire ou carrée.

10. Dispositif anti-chute selon la revendication 3, dans lequel le premier capteur (11) comprend un capteur magnétoélectrique, ou un capteur photoélectrique, et le second capteur (12) comprend un capteur magnétoélectrique, ou un capteur photoélectrique.

11. Véhicule de levage suspendu, comprenant un dispositif anti-chute selon l'une quelconque des revendications 1 à 10, dans lequel le dispositif anti-chute est agencé à l'intérieur du véhicule de levage suspendu, pour permettre à un mécanisme de tringlerie quadrilatère de se déployer au niveau d'une partie inférieure du véhicule de levage suspendu ou de se rétracter à l'intérieur du véhicule de levage suspendu en réponse à l'entraînement du mécanisme de tringlerie quadrilatère par un moteur électrique (4).
